# EUROPÄISCHE PATENTSCHRIFT

(11) **EP 3 602 708 B1**
(45) Veröffentlichungstag und Bekanntmachung des Hinweises auf die Patenterteilung: **27.01.2021**
(21) Anmeldenummer: 18721949.8
(22) Anmeldetag: 19.04.2018
(51) Int. Cl.: H02B 1/30, H02B 1/01, H02B 1/28

(54) **ANORDNUNG AUS EINEM SCHALTSCHRANKRAHMENGESTELL UND EINEM SCHALTSCHRANKSOCKEL**
ARRANGEMENT OF A FRAME OF AN ELECTRICAL CABINET AND A BASE
OSSATURE D'ARMOIRE ÉLECTRIQUE AVEC SOCLE

(30) Priorität: 28.06.2017 DE 102017114385
(43) Veröffentlichungstag der Anmeldung: 05.02.2020
(73) Patentinhaber: Rittal GmbH & Co. KG, 35745 Herborn (DE)
(72) Erfinder: SCHINDLER, Timo, 35075 Gladenbach (DE); REUTER, Wolfgang, 56479 Liebenscheid (DE); KLANER, Thomas, 35274 Kirchhain (DE)
(74) Vertreter: Angerhausen, Christoph
(86) Internationale Anmeldenummer: PCT/DE2018/100376
(87) Internationale Veröffentlichungsnummer: WO 2019/001611

(56) Entgegenhaltungen:
- EP-B1- 0 818 070
- CH-A5- 673 913
- DE-A1- 3 816 516
- DE-A1-102015 121 193
- US-A- 6 164 460
- US-A1- 2011 095 157
- US-B1- 6 359 217

## Beschreibung

Die Erfindung geht aus von einer Anordnung aus einem Schaltschrankrahmengestell und einem Schaltschranksockel, wobei das Schaltschrankrahmengestell eine Mehrzahl Profilstreben und einen rechteckigen Bodenrahmen aufweist, dessen Unterseite eine Außenseite des Schaltschrankrahmengestells ist, die mindestens einen Durchbruch und eine Aufstandsfläche aufweist, über die das Schaltschrankrahmengestell auf dem Schaltschranksockel aufgesetzt ist. Eine derartige Anordnung ist aus der DE 10 2015 121 193 A1 bekannt. Ähnliche Anordnungen zeigen auch die US 6,164,460 A und die US 6,359,217 B1.

Es ist bei Schaltschrankrahmengestellen grundsätzlich wünschenswert, die Unterseite des Bodenrahmens, über die das Schaltschrankrahmengestell auf einer Unterlage aufsteht, als eine durchgängig geschlossene Profilseite des Bodenrahmens auszubilden, um das Eintreten von Feuchtigkeit in das Schaltschrankrahmengestell und damit unter Umständen auch in den mit Hilfe des Schaltschrankrahmengestells geschaffenen Schaltschrank zu verhindern, sodass eine entsprechend hohe IP-Schutzklasse erreicht wird.

Andererseits sind jedoch häufig zumindest im Eckbereich des Bodenrahmens Durchbrüche durch die Unterseite des Bodenrahmens vorgesehen, etwa um das Schaltschrankrahmengestell über den Bodenrahmen auf einem Schaltschranksockel zu verschrauben. Um die zuvor genannten Nachteile derartiger Durchbrüche im Bodenrahmen zu beseitigen, werden zum Beispiel nach dem Verschrauben des Bodenrahmens mit dem Schaltschranksockel verbliebene Durchbrüche im Bodenrahmen mit Stopfen oder dergleichen verschlossen. Dies ist nicht nur vergleichsweise aufwendig und wird häufig vergessen, vielmehr besteht auch immer die Gefahr, dass sich die Stopfen oder anderweitigen Verschlussmittel aus den Durchbrüchen im Nachhinein wieder herauslösen und damit Feuchtigkeit und andere Verunreinigungen in den Schaltschrank gelangen können.

Es ist daher die Aufgabe der Erfindung, ein Schaltschrankrahmengestell der eingangs beschriebenen Art derart weiterzuentwickeln, dass es vor dem Eindringen von

Feuchtigkeit über die Unterseite des Bodenrahmens des Schaltschrankrahmengestells geschützt ist.

Diese Aufgabe wird durch eine Anordnung aus einem Schaltschrankrahmengestell und einem Schaltschranksockel mit den Merkmalen des

Anspruchs 1 gelöst. Die abhängigen Ansprüche betreffen jeweils vorteilhafte Ausführungsformen der Erfindung.

Demgemäß ist vorgesehen, dass der Durchbruch von einer an der Außenseite lösbar montierten Gleitkufe verschlossen ist, die gegenüber der Aufstandsfläche erhaben ist, wobei der Schaltschranksockel eine Vertiefung aufweist, in der die Gleitkufe aufgenommen ist.

Die Gleitkufe kann beispielsweise ein Kunststoffformteil sein, das mit einem einteilig angeformten Befestigungsmittel eingerastet oder im Presssitz in dem Durchbruch festgelegt ist. Die Gleitkufe kann an einer der Außenseite des Bodenrahmens abgewandten Seite eine Gleitfläche aufweisen, die das Verschieben des Schaltschrankrahmengestells erleichtert. Die Gleitkufe kann an einer der Außenseite des Bodenrahmens zugewandten Seite eine Dichtfläche und/oder ein Dichtelement aufweisen. Die Dichtfläche oder das Dichtelement kann um den Durchbruch herum umlaufend geschlossen an der Außenseite fluidisch dichtend anliegen.

Die Gleitkufe hat weiterhin den Vorteil, dass der Bodenrahmen vor Lackabrieb geschützt wird, wenn das Schaltschrankrahmengestell beispielsweise bei der Montage des Schaltschranks über den Boden gezogen wird. Die Gleitkufe kann weiterhin eine Zentrierfunktion aufweisen, welche das Aufstellen des Schaltschrankrahmengestells auf einen Schaltschranksockel erleichtert, indem der Schaltschranksockel eine zu der Gleitkufe korrespondierende Vertiefung aufweist, in welcher die Gleitkufe formschlüssig aufgenommen werden kann.

Dazu weist die Außenseite eine Aufstandsfläche auf, über die das Schaltschrankrahmengestell auf einem Schaltschranksockel aufgesetzt ist. Die Gleitkufe ist dabei gegenüber der Aufstandsfläche erhaben und der Schaltschranksockel, insbesondere eine Deckseite eines Sockeleckstücks des Schaltschranksockels, weist eine Vertiefung auf, in der die Gleitkufe aufgenommen ist. Die Gleitkufe kann zumindest in der Ebene der Aufstandsfläche formschlüssig in der Vertiefung aufgenommen sein.

Um die abdichtende Funktion der Gleitkufe noch weiter zu erhöhen, kann vorgesehen sein, dass die Gleitkufe mindestens eine den mindestens einen Durchbruch umschließende Dichtung aufweist, über die die Gleitkufe an der Unterseite des Bodenrahmens fluidisch dichtend anliegt.

Die Gleitkufe kann ein Befestigungselement, vorzugsweise einen Klemmverbinder oder einen Clipsverbinder aufweisen, der über den Durchbruch in den Bodenrahmen eingreift und in dem Durchbruch festgelegt ist. Sollte es je nach Anwendungsfall erforderlich sein, dass, nachdem das Schaltschrankrahmengestell mit der Gleitkufe auf einem Schaltschranksockel verschraubt worden ist, die Gleitkufe entfernt werden soll, kann vorgesehen sein, dass das Befestigungselement einteilig über eine Sollbruchstelle an die Gleitkufe angeformt ist.

Der rechteckige Bodenrahmen des Schaltschrankrahmengestells kann in mindestens einer seiner vier Ecken, beispielsweise in einem Eckstück des Bodenrahmens, den Durchbruch aufweisen, der von der Gleitkufe verschlossen ist. Vorzugsweise weist der rechteckige Bodenrahmen jedoch in jeder seiner vier Ecken jeweils mindestens einen Durchbruch auf, um das Schaltschrankrahmengestell beispielsweise mit einem Schaltschranksockel zu verschrauben, so dass dementsprechend auch vorgesehen sein kann, dass der Bodenrahmen in jeder seiner vier Ecken eine Gleitkufe aufweist, die den jeweiligen Durchbruch oder die jeweiligen Durchbrüche verschließt.

Die Gleitkufe kann weiterhin dazu vorgesehen sein, um eine Verpackung des Schaltschrankrahmengestells an dem Schaltschrankrahmengestell, insbesondere an der Außenseite des Bodenrahmens des Schaltschrankrahmengestells festzulegen, beziehungsweise um die Verpackung des Schaltschrankrahmengestells vor übermäßiger Reibbelastung zu schützen. Demgemäß kann eine Verpackung des Schaltschrankrahmengestells, beispielsweise ein Kartonage, zwischen der Gleitkufe und der Unterseite des Bodenrahmens angeordnet sein, wobei sich die Gleitkufe mit einem Befestigungselement durch die Verpackung hindurch bis in den zu verschließenden Durchbruch erstreckt.

Dabei kann die Gleitkufe ein Passstück aufweisen, mit dem die Gleitkufe in einen Ausschnitt der Verpackung, vorzugsweise formschlüssig, eingreift. Insbesondere, jedoch nicht zwingend, kann das Passstück an das Befestigungselement angeformt sein. Die Gleitkufe kann an ihrem Außenumfang und an das Passstück angeformt einen Halteflansch aufweisen, der gegenüber der Unterseite des Bodenrahmens um eine Dicke der Verpackung beabstandet ist. Somit kann die Verpackung einerseits über den Formschluss und andererseits über den Halteflansch mit Hilfe der Gleitkufe an der Unterseite des Bodenrahmens festgelegt werden.

Der Halteflansch kann eine Außenkontur aufweisen, die formschlüssig an eine Innenkontur einer Vertiefung in der Deckseite des Schaltschranksockels, insbesondere in der Deckseite eines Sockeleckstücks angepasst ist. Dadurch kann die Gleitkufe in Bezug auf den Schaltschranksockel eine Zentrierfunktion aufweisen, welche die Montage des Schaltschrankrahmengestells auf dem Schaltschranksockel erleichtert, beispielsweise indem korrespondierende Bolzendurchlässe in die Flucht gebracht werden.

Um mit Hilfe der Gleitkufe zusätzlich eine Nivellierfunktion für das Schaltschrankrahmengestell bereitzustellen, kann die Gleitkufe einen sich senkrecht zu der Unterseite erstreckenden Gewindedurchgang, vorzugsweise eine eingespritzte Gewindemutter aufweisen, in die bzw. durch die ein von einer der Unterseite gegenüberliegenden Oberseite des Bodenrahmens zugänglicher Nivellierbolzen geschraubt ist.

Die Gleitkufe kann einen über eine Sollbruchstelle fluidisch verschlossenen Bolzendurchlass aufweisen. Insbesondere dann, wenn die Gleitkufe mehrere Bolzendurchlässe aufweist, um verschiedene Arten der Verschraubung des Schaltschrankrahmengestells an einem Schaltschranksockel zu ermöglichen, ist es sinnvoll, die verschiedenen Bolzendurchlässe über eine Sollbruchstelle, beispielsweise eine Kunststofffolie oder -schicht, zu verschließen, um eine höchstmögliche Abdichtung zu erreichen.

Weiterhin kann die Gleitkufe an ihrem Außenumfang zwei Hebeltaschen aufweisen, die zu dem Außenumfang und zu der Unterseite eines Bodenrahmens eines Schaltschrankrahmengestells hin geöffnet sind. Mithilfe eines Werkzeugs, beispielswiese eines Schlitzschraubendrehers, kann die Gleitkufe über die Hebeltaschen von der Unterseite abgehoben werden.

Das Schaltschrankrahmengestell kann mit dem Bodenrahmen auf einen Schaltschranksockel aufgesetzt sein, wobei der über eine Sollbruchstelle fluidisch verschlossene Bolzendurchlass mit einem zweiten Bolzendurchlass eines Sockeleckstücks des Schaltschranksockels und mit einem dritten Bolzendurchlass des Bodenrahmens fluchtet. Dabei kann vorgesehen sein, dass entweder der zweite oder der dritte Bolzendurchlass ein Innengewinde aufweist, oder diesem ein Innengewinde beispielsweise in Form einer Anschweißmutter beigeordnet ist.

Der Schaltschranksockel kann in jeder seiner vier Ecken ein Sockeleckstück aufweisen, das mindestens einen weiteren Durchbruch durch seine von dem Bodenrahmen abgewandte Bodenseite aufweist, der von einer weiteren Gleitkufe verschlossen ist, die von der Außenseite des Sockeleckstücks an der Bodenseite lösbar montiert ist. Diese Ausführungsform erleichtert insbesondere die Zentrierung, wenn mehrere Schaltschranksockel übereinander gestapelt angeordnet werden sollen, um eine entsprechende Erhöhung des Schaltschrankrahmengestells zu erreichen.

So kann das Schaltschrankrahmengestell auf einem Schaltschranksockel aufgesetzt sein, der an jedem seiner vier Ecken ein Sockeleckstück aufweist, das ein Formteil, insbesondere ein Blechformteil ist, mit einer ersten sowie einer zweiten Außenwand, die sich senkrecht zueinander erstrecken, und mit einer oberen Deckseite und einer unteren Bodenseite, die parallel zueinander und senkrecht zu den Außenwänden angeordnet sind. Die Außenwände, die Deckseite und die Bodenseite können einen Innenraum des Sockeleckstücks abgrenzen, der zu einer Ecke des Formteils hin geöffnet ist.

Weitere Einzelheiten der Erfindung werden anhand der nachstehenden Figuren erläutert. Dabei zeigt:
- Figur 1: eine Draufsicht auf die Oberseite einer Ausführungsform der erfindungsgemäßen Gleitkufe;
- Figur 2: eine schematische Querschnittsansicht einer weiteren Ausführungsform einer erfindungsgemäßen Gleitkufe, die an ihrer Unterseite eines Bodenrahmens montiert ist;
- Figur 3: in perspektivischer Darstellung eine weitere Ausführungsform einer erfindungsgemäßen Gleitkufe sowie eines dazu passenden Sockeleckstücks;
- Figur 4: in perspektivischer Darstellung einen Bodenrahmen, der von seiner Oberseite mit einem Schaltschranksockel verschraubt wird, gemäß einer Ausführungsform der Erfindung;
- Figur 5: eine Seitenansicht eines Bodenrahmens, der über seine Unterseite sowie eine Gleitkufe mit einem Sockeleckstück verschraubt wird;
- Figur 6: eine perspektivische Sicht auf die Unterseite eines Schaltschrankrahmengestells, an dem eine Verpackung mit Hilfe einer Gleitkufe festgelegt ist;
- Figur 7: eine perspektivische Sicht auf die Unterseite einer weiteren Ausführungsform einer erfindungsgemäßen Gleitkufe;
- Figur 8: die Gleitkufe gemäß Figur 7 in einer an der Unterseite eines Bodenrahmens montierten Stellung; und
- Figur 9: eine perspektivische Sicht auf die Oberseite der Anordnung gemäß Figur 8.

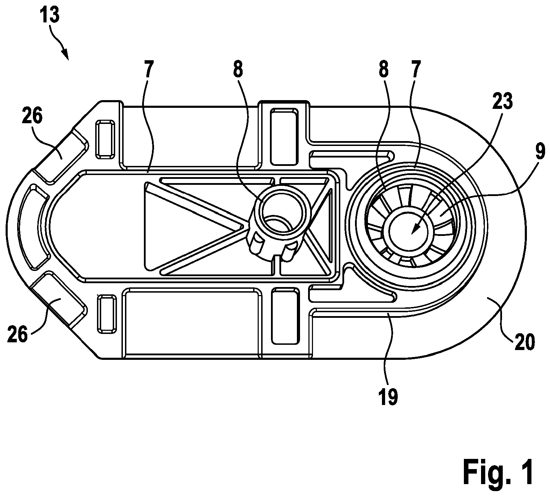

Die Figur 1 zeigt eine Draufsicht auf eine erste Ausführungsform einer Gleitkufe 13. Diese kann insbesondere als Kunststoffformteil, beispielsweise als Spritzgussformteil ausgebildet sein. Die Gleitkufe 13 weist an der gezeigten Oberseite, mit welcher die Gleitkufe 13 der Unterseite eines Bodenrahmens eines Schaltschrankrahmengestells zugewandt auf den Bodenrahmen aufgesteckt werden kann, zwei voneinander beabstandete Befestigungselemente 8 mit unterschiedlichem Durchmesser auf. Die Befestigungselemente 8 sind dazu eingerichtet, im Presssitz oder zumindest im Formschluss in jeweils einem Durchbruch in der Unterseite des Bodenrahmens aufgenommen zu werden, um die Gleitkufe 13 an der Unterseite des Bodenrahmens festzulegen.

Weiterhin weist die Gleitkufe 13 an ihrem Außenumfang zwei Hebeltaschen 26 auf, die zu dem Außenumfang und zu der Unterseite eines Bodenrahmens eines Schaltschrankrahmengestells hin geöffnet sind. Mithilfe eines Werkzeugs, beispielswiese eines Schlitzschraubendrehers, kann die Gleitkufe 13 über die Hebeltaschen von der Unterseite abgehoben werden.

Zur Erhöhung der Abdichtung der Durchbrüche sind die beiden Befestigungselemente 8 von jeweils einer umlaufend geschlossenen Dichtung 7 umgeben. Wenn die Gleitkufe 13 auf die Unterseite des Bodenrahmens aufgesteckt ist, so liegt die Gleitkufe 13 über die gesamte Länge der beiden Dichtungen 7 an, so dass der jeweilige Durchbruch, in welchen die Befestigungselemente 8 eingesetzt sind, gegenüber der Umgebung des Schaltschrankrahmengestells abgedichtet ist. Die Dichtwirkung der Dichtelemente 7 wird noch dadurch erhöht, dass die Dichtungen 7 über das Eigengewicht des Rahmengestells komprimiert werden.

Einer der Befestigungselemente 8 ist als ein Bolzendurchlass 23 ausgebildet, der von einer Sollbruchstelle 9 in Form einer dünnen Kunststoffschicht verschlossen ist. Die Sollbruchstelle 9 kann bei Bedarf, etwa für die Verschraubung des Schaltschrankrahmengestells auf einem Schaltschranksockel durchstoßen werden.

Grundsätzlich ist lediglich ein Befestigungselement 8 notwendig, um die Gleitkufe 13 an der Unterseite eines Bodenrahmens eines Schaltschrankrahmengestells zu befestigen. Die Verwendung mindestens zweier Befestigungselemente 8 hat den Vorteil, dass insbesondere im Fall kreissymmetrischer Befestigungselemente 8 die Gleitkufe bereits mit ihrer Montage am Schaltschrankrahmengestell präzise vorpositioniert ist. Es ist jedoch denkbar, dass insbesondere das als Bolzendurchlass 23 ausgebildete Befestigungselement 8 selbst keine Befestigungsfunktion aufweist oder lediglich über einen geringen Vorsprung in einen entsprechenden Durchbruch in der Unterseite des Bodenrahmens eintritt, um die Gleitkufe 13 in Bezug auf den Bodenrahmen vorzupositionieren, während die Haltefunktion von dem weiteren Befestigungselement 8 bereitgestellt wird.

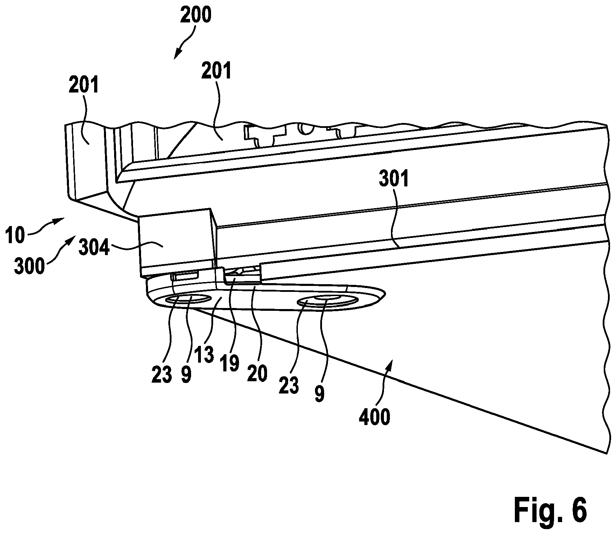

Die Gleitkufe 13 weist weiterhin ein Passstück 19 auf, welches dazu eingerichtet ist, mit seiner Außenkontur in einen entsprechenden Ausschnitt in einer Bodenkartonage des Schaltschrankrahmengestells einzudringen, während die Kartonage von dem das Passstück 19 umgebenden Halteflansch 20 überlappt und damit an der Unterseite des Bodenrahmens gehalten wird. Insbesondere kann mindestens eines der Befestigungselemente 8 dazu eingerichtet sein, sich durch die Verpackung, insbesondere die Bodenkartonage hindurch und bis in den Durchbruch in der Unterseite des Bodenrahmens hinein zu erstrecken, wo das Befestigungselemente in der bereits beschriebenen Weise an dem Bodenrahmen beispielsweise durch Presssitz festgelegt wird, so dass auch die Bodenkartonage an dem Bodenrahmen gehalten wird. Dies ist in Figur 6 gezeigt. Hier ist insbesondere zu erkennen, dass der Halteflansch 20 zu einer oberen Anlageseite der Gleitkufe 13, über welche die Gleitkufe 13 an der Unterseite 301 des Bodenrahmens 300 des Schaltschrankrahmengestells 200 anliegt, einen Abstand aufweist, der gerade einer Dicke der Kartonage 400 entspricht. Der Bodenrahmen 300 weist ein Eckstück 304 mit einer vertikalen Gewindebohrung auf, über welche das Schaltschrankrahmengestell 200 mit einem Sockeleckstück verschraubt werden kann. Dabei kann die Gleitkufe 13 an der Unterseite 301 des Bodenrahmens montiert bleiben. Insbesondere weist die Gleitkufe 13 einen Bolzendurchlass 23 auf, der mit dem Innengewinde des Eckstücks 304 fluchtet. Der Bolzendurchlass 23 kann insbesondere durch eine Sollbruchstelle 9 verschlossen sein.

Ein weiterer über eine Sollbruchstelle 9 verschlossener Bolzendurchlass 23 ist beabstandet von dem Eckstück 304 angeordnet, um eine alternative Art der Verschraubung des Bodenrahmens 300 mit dem Schaltschranksockel, insbesondere eines Sockeleckstücks, zu erlauben.

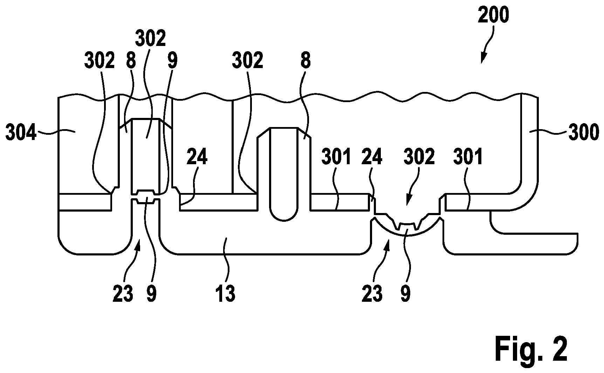

Die Figur 2 zeigt eine Querschnittsansicht einer an einer Unterseite 301 eines Bodenrahmens 300 eines Schaltschrankrahmengestells 200 montierten Gleitkufe 13. Die Unterseite 301 weist drei Durchbrüche 302 auf, die über die Gleitkufe 13 verschlossen sind. Soweit die Gleitkufe 13 mit dem jeweiligen Durchbruch 302 fluchtende Bolzendurchlässe 23 aufweist, so sind diese mit einer Sollbruchstelle 9 verschlossen, um eine zuverlässige Abdichtung des Bodenrahmens 300 zu seiner Unterseite 301 hin zu gewährleisten, wann immer der jeweilige Bolzendurchlass 302 nicht für die Verschraubung des Bodenrahmens, beispielsweise mit einem Schaltschranksockel, verwendet wird.

Neben der den Bolzendurchlass 23 verschließenden Sollbruchstelle 9 weist der in der Darstellung gemäß Figur 2 linke Bolzendurchlass 23 eine weitere Sollbruchstelle 9 auf, über welche das den genannten Bolzendurchlass 23 umgebende Befestigungselement 8 an die Gleitkufe 13 angeformt ist. Diese Sollbruchstelle kann dabei behilflich sein, die Gleitkufe 13 nachträglich von der Unterseite 301 des Bodenrahmens 300 wieder abzulösen. Vorzugsweise kann dazu das in der Darstellung rechte Befestigungselement 8 ebenso über eine entsprechende Sollbruchstelle 9 an die Gleitkufe 13 angeformt sein. Die Gleitkufe 13 ist vorliegend insbesondere als ein einteiliges Spritzgussformteil, insbesondere als ein Kunststoffformteil ausgebildet.

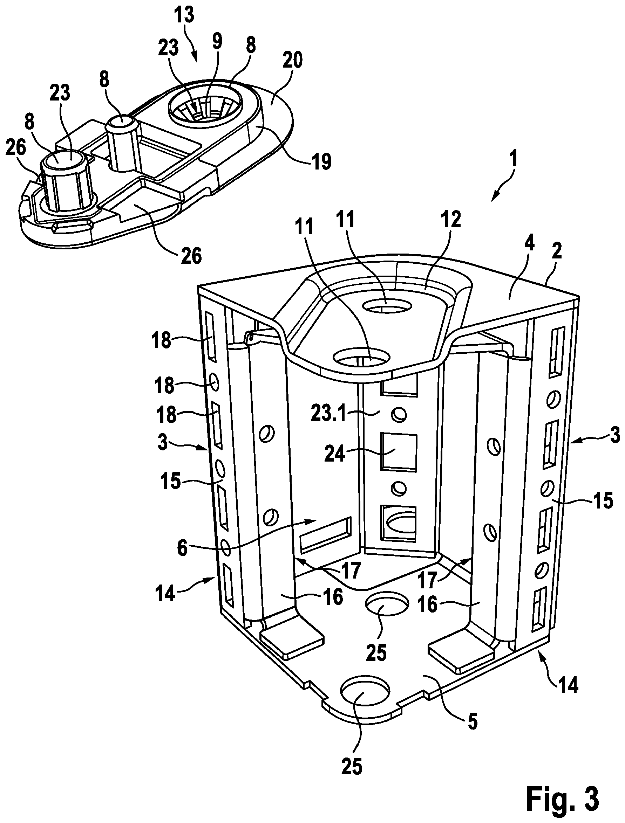

Die Figur 3 veranschaulicht eine weitere Funktionalität einer Ausführungsform der erfindungsgemäßen Gleitkufe. Diese besteht darin, dass die Gleitkufe 13 dazu verwendet werden kann, in Verbindung mit einem entsprechend ausgeformten Sockelrahmen das Schaltschrankrahmengestell mit der mindestens einen an seiner Unterseite des Bodenrahmens montierten Gleitkufe 13 gegenüber dem Sockelrahmen vorauszurichten. Insbesondere kann der Halteflansch 20 am Außenumfang der Gleitkufe 13 eine Außenkontur aufweisen, die einer Innenkontur einer Vertiefung 13 in der Deckseite 14 des gezeigten Sockeleckstücks 1 entspricht. Die so erreichte Vorausrichtung kann beispielsweise dazu dienen, die beiden Bolzendurchlässe 11 in der Deckseite 4 des Sockeleckstücks 1 in Bezug auf den Bolzendurchlass 23 und das in der Darstellung vordere Befestigungselement 8 der Gleitkufe 13 vorauszurichten, so dass einer der Bolzendurchlässe 11 mit dem Bolzendurchlass 23 fluchtet und der andere Bolzendurchlass 11 mit dem Befestigungselement 8, das den weiteren Bolzendurchlass 23 aufweist, fluchtet.

Das in Figur 3 gezeigte Sockeleckstück 1 weist ein Formteil 2 auf, das insbesondere als ein Blechformteil ausgebildet sein kann. Das Blechformteil 2 besteht im Wesentlichen aus einer Deckseite 4, einer Bodenseite 5 sowie zwei Außenwänden 3, die sich senkrecht zu der Deckseite 4 und der Bodenseite 5 erstrecken und diese unter einem Abstand miteinander verbinden. Die Außenwände 3 sind über eine Verbindungsseite 23.1 miteinander verbunden, die sich jeweils unter einem 45°-Winkel zu den Außenwänden 3 erstreckt. Die Außenwände 3 und die Verbindungsseite 23.1 sind einteilig ausgeführt und die Verbindungsseite 23.1 weist eine Lochung aus regelmäßig beabstandeten Rechteckdurchbrüchen 24 auf.

Die Deckseite 4 weist eine muldenförmige Vertiefung 12 auf, in die die Gleitkufe 13 formschlüssig eingesetzt werden kann. Aufgrund der formschlüssigen Konturen von Gleitkufe 13 und muldenförmiger Vertiefung 12 wird eine exakte Vorpositionierung des Schaltschrankrahmengestells in Bezug auf das Sockeleckstück 1, insbesondere in Bezug auf die Deckseite 4 des Blechformteils 2 erreicht, so dass ein komfortables Verschrauben von Blechformteil 2 und Schaltschrankrahmengestell möglich ist.

An den von der Verbindungsseite 23.1 angewandten freien Enden weisen die Außenwände 3 jeweils eine U-Umkantung 14 auf, mit einer sich senkrecht zu der Außenwand 3 erstreckenden ersten Profilseite 15 und einer an die erste Profilseite 15 angeformten zweiten Profilseite 16, die sich parallel zu der Außenwand 3 erstreckt und eine im Innenraum 6 angeordnete freie Kante 17 aufweist, die gegenüber der Außenwand 3 beabstandet ist. Die erste Profilseite 15 weist eine Systemlochung 18 aus regelmäßig beabstandeten rechteckigen und runden Durchbrüchen auf. Die zweite Profilseite 16 weist weitere Rundlöcher auf, die insbesondere für die Festlegung von Sockelblenden dienen können.

Das Blechformteil 2 kann durch Stanzen, Kanten und Schweißen eines Metallblechs erhalten werden, wobei die muldenförmige Vertiefung 12 beispielsweise im Zuge eines Prägevorgangs ausgebildet werden kann. Das Blechformteil 2 ist damit im Vergleich zu aus dem Stand der Technik bekannten Spritzgusssockeleckstücken kostengünstig herstellbar.

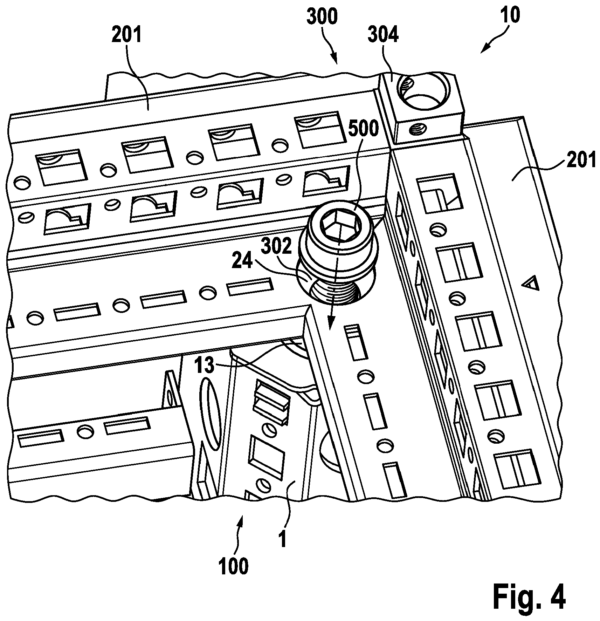

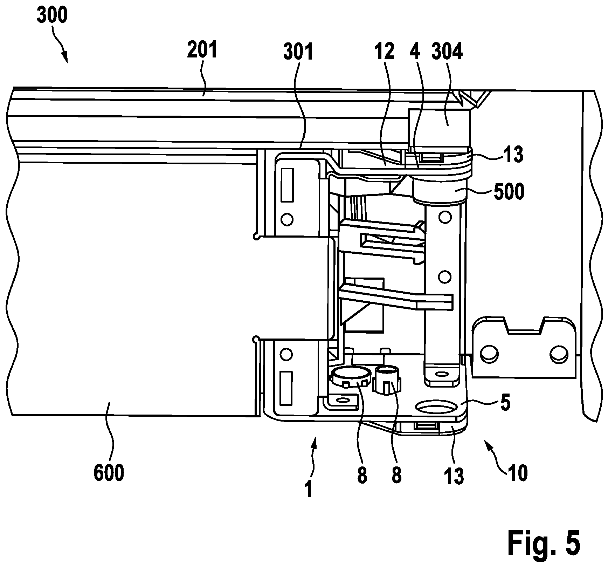

In der Zusammenschau mit den Figuren 2 und 3 zeigen die Figuren 4 und 5 zwei mögliche Arten der Verschraubung des Bodenrahmens 300 eines Schaltschrankrahmengestells 200 mit dem Sockeleckstück 1 eines Schaltschranksockels 100 sowie mit Hilfe einer zwischen dem Bodenrahmen 300 und dem Schaltschranksockel 100 angeordneten Gleitkufe 13. Bei der in Figur 4 gezeigten Ausführungsform wird ein Schraubbolzen 500 über die Oberseite des Bodenrahmens 300 durch einen Durchbruch 302 des Bodenrahmens 300 sowie einen Bolzendurchlass 24 in der Gleitkufe 13 mit dem Sockeleckstück 1 des Schaltschranksockels 100 verschraubt. Dazu kann das Sockeleckstück 1 etwa entsprechend der in Figur 3 gezeigten Ausführungsform ausgebildet sein, wobei der in der Darstellung gemäß Figur 3 hintere Bolzendurchlass 11, der der Verbindungsseite 23.1 näher beigeordnet ist, eine an der Unterseite seiner Deckseite angeordnete Gewindemutter aufweisen kann, in die der Schraubbolzen 500 eingeschraubt werden kann. Im Vergleich dazu ist bei der in Figur 5 gezeigten Ausführungsform der Schraubbolzen ausgehend von der Deckseite 4 durch die Gleitkufe 13 in ein Innengewinde in dem Eckstück 304 des Bodenrahmens 300 eingeschraubt, wobei hierbei der Bolzen 500 durch den in der Darstellung gemäß Figur 3 vorderen Bolzendurchlass 11 hindurchtritt.

Weiterhin tritt der Bolzen 500 bei der Ausführungsform gemäß Figur 4 durch den Bolzendurchlass 23 der Gleitkufe 13 durch, der von dem Passstück 19 umgeben ist, während bei der Ausführungsform gemäß Figur 5 der Bolzen 500 durch den weiteren Bolzendurchlass 23 der Gleitkufe 13 am spitzen Ende der Gleitkufe 13 hindurchtritt.

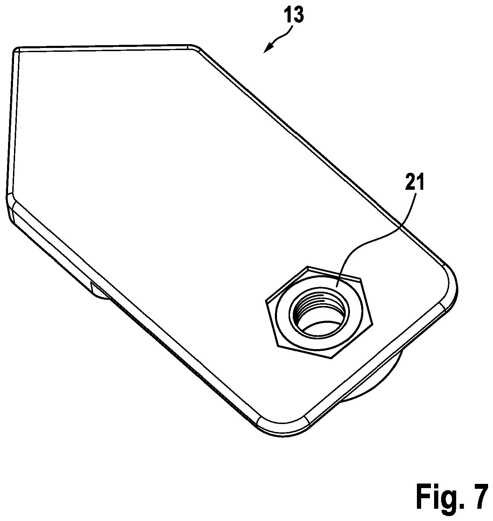

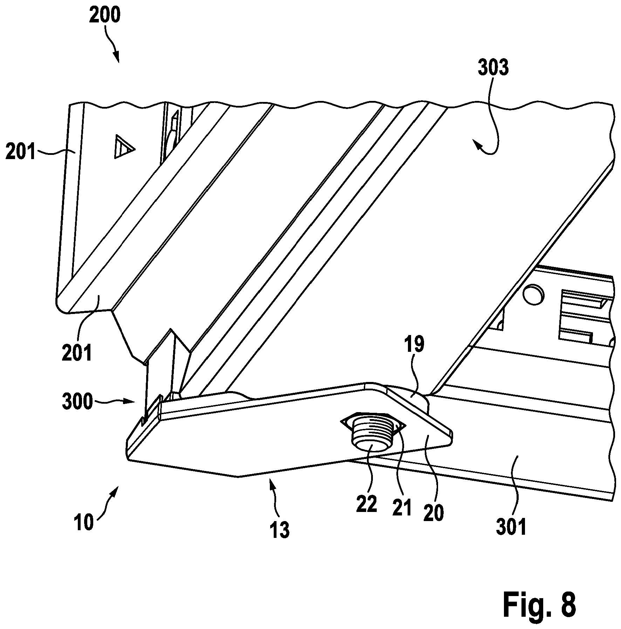

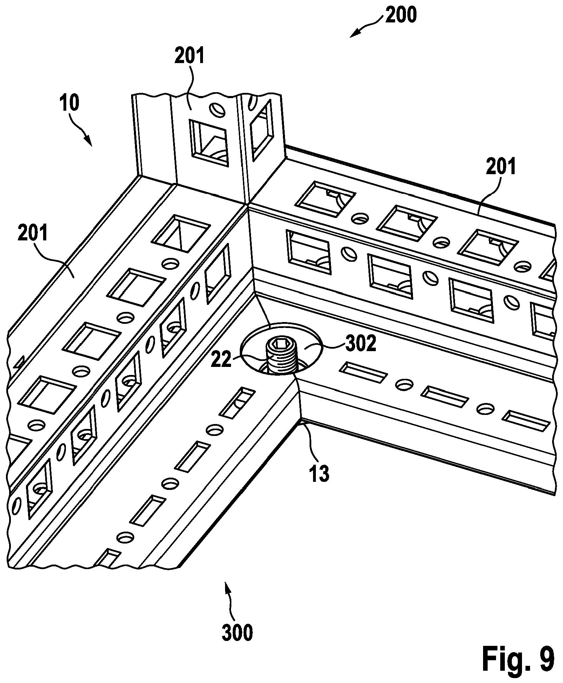

Die Figuren 7 bis 9 veranschaulichen eine weitere Funktionalität einer Ausführungsform der erfindungsgemäßen Gleitkufe 13. Diese weist senkrecht zu ihrer Aufstandsfläche einen Bolzendurchlass auf, der einen Gewindedurchgang 21 aufweist, welcher beispielsweise in Form einer in die als Kunststoffspritzgussformteil ausgebildete Gleitkufe eingespritzte Gewindemutter ausgebildet sein kann. Die Figuren 8 und 9 zeigen, dass die an der Aufstandsfläche 303 des Bodenrahmens 300 festgelegte Gleitkufe 13 zur Aufnahme eines Nivellierbolzens 22 in dem Gewindedurchgang 21 dienen kann, wobei der Nivellierbolzen entsprechend Figur 9 von der Oberseite des Bodenrahmens über einen Durchbruch 302 in dem Bodenrahmen 300 zugänglich ist. Der Nivellierbolzen 23 weist an dem der Oberseite des Bodenrahmens 300 zugewandten Ende einen Antrieb auf, der in Form eines Innensechskants ausgebildet ist. Gemäß Figur 8 ragt der Nivellierbolzen 23 mit einem freien Ende über die Aufstandsfläche 300 aus der Gleitkufe 13 heraus und ist in Richtung senkrecht zu der Aufstandsfläche 303 durch Verdrehen verstellbar, so dass eine Nivellierfunktion bereitgestellt wird.

### Bezugszeichenliste

- 1: Sockeleckstück
- 2: Formteil
- 3: Außenwand
- 4: Deckseite
- 5: Bodenseite
- 6: Innenraum
- 7: Dichtung
- 8: Befestigungselement
- 9: Sollbruchstelle
- 10: Ecke
- 11: zweiter Bolzendurchlass
- 12: Vertiefung
- 13: Gleitkufe
- 14: U-Umkantung
- 15: erste Profilseite
- 16: zweite Profilseite
- 17: Kante
- 18: Systemlochung
- 19: Passstück
- 20: Halteflansch
- 21: Gewindedurchgang
- 22: Nivellierbolzen
- 23: Bolzendurchlass
- 23.1: Verbindungsseite
- 24: dritter Bolzendurchlass
- 25: weiterer Durchbruch
- 26: Hebeltasche
- 100: Schaltschranksockel
- 200: Schaltschrankrahmengestell
- 201: Profilstrebe
- 300: Bodenrahmen
- 301: Unterseite
- 302: Durchbruch
- 303: Aufstandsfläche
- 304: Eckstück
- 400: Verpackung
- 401: Ausschnitt
- 500: Bolzen
- 600: Doppelblende

## Patentansprüche

1. Anordnung aus einem Schaltschrankrahmengestell (200) und einem Schaltschranksockel, wobei das Schaltschrankrahmengestell (200) eine Mehrzahl Profilstreben (201) und einen rechteckigen Bodenrahmen (300) aufweist, dessen Unterseite (301) eine Außenseite des Schaltschrankrahmengestells (200) ist, die mindestens einen Durchbruch (302) und eine Aufstandsfläche (303)aufweist, über die das Schaltschrankrahmengestell (200) auf dem Schaltschranksockel (100) aufgesetzt ist, **dadurch gekennzeichnet, dass** der Durchbruch (302) von einer an der Außenseite lösbar montierten Gleitkufe (13) verschlossen ist, die gegenüber der Aufstandsfläche (303) erhaben ist, wobei der Schaltschranksockel (100) eine Vertiefung (12) aufweist, in der die Gleitkufe (13) aufgenommen ist.

2. Anordnung nach Anspruch 1, bei dem eine Deckseite (4) eines Sockeleckstücks (1) des Schaltschranksockels (100) die Vertiefung (12) aufweist, in der die Gleitkufe (13) aufgenommen ist.

3. Anordnung nach Anspruch 1, bei dem die Gleitkufe (13) zumindest in der Ebene der Aufstandsfläche (303) formschlüssig in der Vertiefung (12) aufgenommen ist.

4. Anordnung nach einem der vorangegangen Ansprüche, bei dem die Gleitkufe (13) mindestens eine den mindestens einen Durchbruch (302) umschließende Dichtung (7) aufweist, über die die Gleitkufe (13) an der Unterseite (301) des Bodenrahmens (300) fluidisch dichtend anliegt.

5. Anordnung nach einem der vorangegangen Ansprüche, bei dem die Gleitkufe (13) ein Befestigungselement (8), vorzugsweise einen Klemmverbinder oder einen Clipsverbinder, aufweist, der über den Durchbruch (302) in den Bodenrahmen (300) eingreift und in dem Durchbruch (302) festgelegt ist.

6. Anordnung nach einem der vorangegangen Ansprüche, bei dem der rechteckige Bodenrahmen (300) in mindestens einer seiner vier Ecken (10) den Durchbruch (302) aufweist, der von der Gleitkufe (13) verschlossen ist.

7. Anordnung nach einem der vorangegangen Ansprüche, bei dem eine Verpackung (400) des Schaltschrankrahmengestells (200), vorzugsweise eine Kartonage, zwischen der Gleitkufe (13) und der Unterseite (301) des Bodenrahmens (300) angeordnet ist, wobei sich die Gleitkufe (13) mit einem Befestigungselement (8) durch die Verpackung (400) hindurch bis in den Durchbruch (302) erstreckt.

8. Anordnung nach Anspruch 7, bei dem an das Befestigungselement (8) ein Passstück (19) der Gleitkufe (13) angeformt ist, mit dem die Gleitkufe (13) in einen Ausschnitt (401) der Verpackung (400) vorzugsweise formschlüssig eingreift.

9. Anordnung nach Anspruch 8, bei dem die Gleitkufe (13) an ihrem Außenumfang und an das Passstück (19) angeformt einen Halteflansch (20) aufweist, der gegenüber der Unterseite (301) des Bodenrahmen (300) um eine Dicke der Verpackung (400) beabstandet ist.

10. Anordnung nach einem der vorangegangen Ansprüche, bei dem die Gleitkufe (13) einen sich senkrecht zu der Unterseite (301) erstreckenden Gewindedurchgang (21), vorzugsweise eine eingespritzte Gewindemutter aufweist, in die ein von einer der Unterseite (301) gegenüber liegenden Oberseite des Bodenrahmens (300) zugänglicher Nivellierbolzen (22) eingeschraubt ist.

11. Anordnung nach einem der vorangegangen Ansprüche, bei dem die Gleitkufe (13) einen über eine Sollbruchstelle (9) fluiddicht verschlossenen Bolzendurchlass (23) aufweist.

12. Anordnung nach Anspruch 11, wobei der über eine Sollbruchstelle (9) fluiddicht verschlossene Bolzendurchlass (23) mit einem zweiten Bolzendurchlass (11) eines Sockeleckstücks (1) des Schaltschranksockels (100) und mit einem dritten Bolzendurchlass (24) des Bodenrahmens (300) fluchtet, und wobei entweder der zweite oder der dritte Bolzendurchlass (11, 24) ein Innengewinde aufweist.

13. Anordnung nach Anspruch 1, bei dem der Schaltschranksockel (100) in jeder seiner vier Ecken (10) ein Sockeleckstück (1) aufweist, das mindestens einen weiteren Durchbruch (25) durch seine von dem Bodenrahmen (300) abgewandte Bodenseite (5) aufweist, der von einer weiteren Gleitkufe (13) verschlossen ist, die von der Außenseite des Sockeleckstücks (1) an der Bodenseite (5) lösbar montiert ist.

14. Anordnung nach einem der vorangegangen Ansprüche, wobei der Schaltschranksockel (100) an jedem seiner vier Ecken ein Sockeleckstück (1) aufweist, das ein Formteil (2), insbesondere ein Blechformteil, ist, mit einer ersten sowie einer zweiten Außenwand (3), die sich senkrecht zueinander erstrecken, und mit einer oberen Deckseite (4) und einer unteren Bodenseite (5), die parallel zueinander und senkrecht zu den Außenwänden (3) angeordnet sind, wobei die Außenwände (3), die Deckseite (4) und die Bodenseite (5) einen Innenraum (6) des Sockeleckstücks (1) abgrenzen, der zu einer Ecke des Formteils (2) hin geöffnet ist.

15. Anordnung nach einem der vorangegangen Ansprüche, bei dem die Gleitkufe (13) an ihrem Außenumfang zwei Hebeltaschen (26) aufweist, die zum Außenumfang der Gleitkufe (13)und zu der Unterseite des Bodenrahmens hin geöffnet sind.

## Claims

1. An arrangement comprising a switch cabinet frame (200) and a switch cabinet base, wherein the switch cabinet frame (200) comprises multiple profile struts (201) and a rectangular base frame (300), the underside (301) of which is an outer side of the switch cabinet frame rack (200), which has at least one through-opening (302) and a contact surface (303) via which the switch cabinet frame (200) is placed on the switch cabinet base (100), **characterized in that** the through-opening (302) is closed by a skid (13) which is detachable mounted on the outer side, which is raised relative to the contact surface (303), wherein the switch cabinet base (100) has a recess (12) in which the skid (13) is received.

2. The arrangement according to claim 1, in which a cover side (4) of a base corner piece (1) of the base frame (300) has the recess (12) in which the skid (13) is accommodated.

3. The arrangement according to claim 1, in which the skid (13) is positively accommodated in the recess (12) at least in the plane of the contact surface (303).

4. The arrangement according to any of the preceding claims, in which the skid (13) has at least one seal (7) enclosing the at least one through-opening (302), via which the skid (13) lies against the underside (301) of the base frame (300) in a fluidically sealing manner.

5. The arrangement according to any of the preceding claims, in which the skid (13) has a fastening element (8), preferably a clamp connector or a clip connector, which engages in the base frame (300) via the through-opening (302) and is fixed in the through-opening (302).

6. The arrangement according to any of the preceding claims, in which the rectangular base frame (300) has the through-opening (302), which is closed by the skid (13), in at least one of its four corners (10).

7. The arrangement according to any of the preceding claims, in which a packaging (400) of the switch cabinet frame rack (200), preferably a cardboard box, is arranged between the skid (13) and the underside (301) of the base frame (300), wherein the skid (13) with a fastening element (8) extends through the packaging (400) into the through-opening (302).

8. The arrangement according to claim 7, in which a fitting piece (19) is formed on the fastening element (8), with which the skid (13) engages in a cut-out (401) of the packaging (400), preferably in a positive-fitting manner.

9. The arrangement according to claim 8, in which the skid (13) has a support flange (20) formed on its outer circumference and on the fitting piece (19), which support flange is spaced apart from the underside (301) of the base frame(300) by a thickness of the packaging (400).

10. Switch cabinet frame rack (200) according to any of the preceding claims, in which the skid (13) has a threaded passage (21) extending perpendicularly to the underside (301), preferably an injected threaded nut, into which a levelling bolt (22) accessible from an upper side of the base frame (300) opposite the underside (301) is screwed.

11. The arrangement according to any of the preceding claims, in which the skid (13) has a bolt passage (23) fluidically closed by a predetermined breaking point (9).

12. The arrangement according to claim 11, wherein the bolt passage (23), which is fluidically closed via a predetermined breaking point (9), is aligned with a second bolt passage (11) of a base corner piece (1) of the switch cabinet base (100) and with a third bolt passage (24) of the base frame (300), and wherein either the second or the third bolt passage (11, 24) has an internal thread.

13. The arrangement according to claim 1, in which the switch cabinet base (100) has in each of its four corners a base corner piece (1), which has at least one further through-opening (25) through its base side (5) facing away from the base frame (300), which is closed by another skid (13) which is detachably mounted on the base side (5) from the outer side of the base corner piece (1).

14. The arrangement according to any of the preceding claims, in which the switch cabinet base (100) has at each of its four corners a base corner piece (1) which is a shaped part (2), in particular a sheet metal shaped part, with a first and a second outer wall (3) which extend perpendicular to each other and with an upper cover side (4) and a lower base side (5) which are arranged parallel to each other and perpendicular to the outer walls (3), wherein the outer walls (3), the cover side (4) and the base side (5) delimit an interior space (6) of the base corner piece (1) which is open towards a corner of the shaped part (2).

15. The arrangement according to any of the preceding claims, in which the skid has two lever pockets (26) on its outer circumference, which are open to the outer circumference of the skid (13) and to the underside of the base frame.

## Revendications

1. Disposition constituée d'un châssis d'armoire de commande (200) et d'un socle d'armoire de commande, dans laquelle le châssis d'armoire de commande (200) comprend une pluralité de montants profilés (201) et un cadre de fond rectangulaire (300), dont la face inférieure (301) est une face extérieure du châssis d'armoire de commande (200), qui comprend au moins une percée (302) et une surface d'appui (303) grâce à laquelle le châssis d'armoire de commande (200) est posé sur le socle d'armoire de commande (100), **caractérisée en ce que** la percée (302) est fermée par un patin de glissement (13) monté de manière amovible sur la face extérieure, qui est surélevé par rapport à la surface d'appui (303), dans laquelle le socle d'armoire de commande (100) comprend une cavité (12) dans laquelle est logé le patin de glissement (13).

2. Disposition selon la revendication 1, dans laquelle une face de recouvrement (4) d'une pièce angulaire de socle (1) du socle d'armoire de commande (100) comprend la cavité (12) dans laquelle est logé le patin de glissement (13).

3. Disposition selon la revendication 1, dans laquelle le patin de glissement (13) est logé, au moins dans le plan de la surface d'appui (303), par complémentarité de forme dans la cavité (12).

4. Disposition selon l'une des revendications précédentes, dans laquelle le patin de glissement (13) comprend au moins un joint d'étanchéité (7) entourant l'au moins une percée (302), par l'intermédiaire duquel le patin de glissement (13) s'appuie de manière étanche aux fluides contre la face inférieure (301) du cadre de fond (300).

5. Disposition selon l'une des revendications précédentes, dans laquelle le patin de glissement (13) comprend un élément de fixation (8), de préférence un raccord de serrage ou un raccord à clip, qui s'emboîte par l'intermédiaire de la percée (302) dans le cadre de fond (300) et qui est fixé dans la percée (302).

6. Disposition selon l'une des revendications précédentes, dans laquelle le cadre de fond rectangulaire (300) comprend, dans au moins un de ses quatre angles (10), la percée (302), qui est fermée par le patin de glissement (13).

7. Disposition selon l'une des revendications précédentes, dans laquelle un emballage (400) du châssis d'armoire de commande (200), de préférence un cartonnage, est disposé entre le patin de glissement (13) et la face arrière (301) du cadre de fond (300), dans laquelle le patin de glissement (13) s'étend avec un élément de fixation (8) à travers l'emballage (400) jusque dans la percée (302).

8. Disposition selon la revendication 7, dans laquelle, sur l'élément de fixation (8), est formé une pièce d'ajustement (19) du patin de glissement (13) avec laquelle le patin de glissement (13) s'emboîte dans une découpe (401) de l'emballage (400), dans préférence par complémentarité de forme.

9. Disposition selon la revendication 8, dans laquelle le patin de glissement (13) comprend, formée sur sa circonférence externe et sur la pièce d'ajustement (19), une bride de maintien (20) qui est distant de la face inférieure (301) du cadre de fond (300) d'une épaisseur de l'emballage (400).

10. Disposition selon l'une des revendications précédentes, dans laquelle le patin de glissement (13) comprend, dans un passage fileté (21) s'étendant perpendiculairement à la face inférieure (301), de préférence un écrou fileté injecté, dans lequel est vissée une tige de nivellement (22) accessible par une face supérieure opposée à la face arrière (301) du cadre de fond (300).

11. Disposition selon l'une des revendications précédentes, dans laquelle le patin de glissement (13) comprend un passage de tige (23) fermé de manière étanche aux fluides par un point de rupture prédéterminé (9).

12. Disposition selon la revendication 11, dans laquelle le passage de tige (23) fermé de manière étanche aux fluides par l'intermédiaire d'un point de rupture prédéterminé (9) est aligné avec un deuxième passage de tige (11) d'une pièce angulaire de socle (1) du socle d'armoire de commande (100) et avec un troisième passage de tige (24) du cadre de fond (300) et dans laquelle soit le deuxième soit le troisième passage de tige (11, 24) présente un filetage interne.

13. Disposition selon la revendication 1, dans laquelle le socle d'armoire de commande (100) comprend, dans chacun de ses quatre angles (10), une pièce angulaire de socle (1) qui comprend au moins une percée supplémentaire (25) à travers sa face de fond (5) opposée au cadre de fond (300), qui est fermée par un patin de glissement supplémentaire (13) qui est monté de manière amovible à partir de la face extérieure de la pièce angulaire de socle (1) sur la face de fond (5).

14. Disposition selon l'une des revendications précédentes, dans laquelle le socle d'armoire de commande (100) comprend, au niveau de chacun de ses quatre angles, une pièce angulaire de socle (1) qui est une pièce moulée (2), plus particulièrement une pièce moulée en tôle, avec une première ainsi qu'une deuxième parois externes (3), qui s'étendent perpendiculairement entre elles et avec une face de recouvrement supérieure (4) et une face de fond inférieure (5), qui sont disposées parallèlement entre elles et perpendiculairement aux parois externes (3), dans laquelle les parois externes (3), la face de recouvrement (4) et la face de fond (5) délimitent un espace interne (6) de la pièce angulaire de socle (1), qui est ouverte en direction d'un angle de la pièce moulée (2).

15. Disposition selon l'une des revendications précédentes, dans laquelle le patin de glissement (13) comprend, sur sa circonférence externe, deux poches à leviers (26) qui sont ouvertes en direction de la circonférence externe du patin de glissement (13) et en direction de la face inférieure du cadre de fond.
